# EUROPEAN PATENT APPLICATION

(11) **EP 3 333 230 A1**
(43) Date of publication of application: **13.06.2018**
(21) Application number: 16202845.0
(22) Date of filing: 08.12.2016
(51) Int. Cl.: C09D 11/10, C09D 11/52, C23C 14/28, H01L 21/285

(54) **A COMPOSITION SUITABLE FOR APPLICATION WITH LASER INDUCED FORWARD TRANSFER (LIFT)**

(71) Applicant: Henkel AG & Co. KGaA, 40589 Düsseldorf (DE)
(72) Inventor: VAN DER MEULEN, Inge, 5504 MJ Veldhoven (NL); DREEZEN, Gunther, 2491 Balen - Olmen (BE); WIJGAERTS, Jan, 3550 Heusden-Zolder (BE); ARUTINOV, Gari, 5611DL Eindhoven (NL); GIESBERS, Merijn, 5508LD Veldhoven (NL)

(57) **Abstract**

The present invention relates to a composition comprising a) one or more resin; b) electrically conductive particles and/or non-conductive particles and/or thermally conductive particles; and c) from 5 to 40% of a volatile by weight of the total weight of the composition, wherein said volatile has a boiling point higher than 130°C, and wherein said composition has no crossing over of the storage modulus (G') and the loss modulus (G"), and wherein the storage modulus (G') is lower than the loss modulus (G"). A composition according to the present invention is suitable for application with laser Induced Forward Transfer (LIFT).

## Description

### Technical field

The present invention relates to a composition suitable for application with Laser Induced Forward Transfer (LIFT).

### Background

The downsizing of components like microelectromechanical systems (MEMS) is challenging for the industry standard application technologies like dispensing, printing, jetting or pin transfer. Currently used dispense technologies have all reached their limits in regards volume and/or dot size and the required process speed. The limit in dot size for jetting technology is around 200 µm for standard materials used in the industry. Needle dispensing and pin transfer both can go down till 75 µm on dot size, however, the process speed will be negatively impacted, and therefore, a very accurate and expensive robot system is required. Printing, on the other hand, is a very fast technique, however, the resolution is low and only large dots can be produced. With dispensing, smaller dot sizes can be produced with reasonably high resolution, however, this technique is slower and less reproducible compared to printing.

A recent development in this area is the Laser Induced Forward Transfer (LIFT) process. In the LIFT, a pulsed laser beam is directed through a laser-transparent target substrate to strike a film of material coated on the opposite side of the target substrate (donor layer). The laser vaporizes the film material as it absorbs the laser radiation and, due to the transfer of momentum, the material is removed from the target substrate and is redeposited on a receiving substrate that is placed in proximity to the target substrate. LIFT is typically used to transfer opaque thin films, typically metals, from a pre-coated laser transparent support, typically glass, SiO₂, Al₂O₃, SrTiO₃, etc., to the receiving substrate. The LIFT technique combines the best between jetting and dispensing techniques, it is fast and very reproducible and very small dot sizes with high resolution can be obtained. LIFT technology has proven to be able apply dots of <80 µm with a process speed of >1000 dots per second. Additionally, the robot systems required for LIFT do not need the same accuracy. LIFT technology will also enable further downsizing of components and devices.

Because the film material is vaporized by the action of the laser, LIFT is inherently a pyrolytic technique, and is generally used to deposit simple one-component materials. Typically LIFT cannot be used to deposit complex crystalline, multi-component materials as they tend to decompose when vaporized and may become amorphous upon condensation. Moreover, because the material to be transferred is vaporized, it becomes more reactive and can more easily become degraded, oxidized, or contaminated. Generally the LIFT is not well suited for the transfer of organic materials, since many organic materials are fragile, thermally labile, and can be irreversibly damaged during deposition. Furthermore, functional groups on an organic polymer may be irreversibly damaged by direct exposure to laser energy.

It is well known that adhesives can be made suitable for screen printing, jetting, pin transfer and dispensing, however this has not been equally straightforward process for the LIFT process. There is a need for the LIFT process to be available for complex materials. Therefore, there is a need for a composition based on complex materials, which is ideal for use in LIFT process.

### Short description of the figures

Figure 1 illustrates storage and loss moduli of compositions A1, A2 and A3.
Figure 2 illustrates storage modulus (G') vs. loss modulus (G")
Figure 3 illustrates not LIFT-able and non-reproducible dots produced from the comparative composition.
Figure 4 illustrates effect of viscosity of the composition in LIFT process.
Figure 5 illustrates effect of boiling point of the volatile in LIFT process.
Figure 6 illustrates effect of volatile quantity in the composition in LIFT process.
Figure 7 illustrates good LIFT-able and reproducible dots produced from the composition according to the present invention.

### Summary of the invention

The present invention relates to a composition comprising a) one or more resin; b) electrically conductive particles and/or non-conductive particles and/or thermally conductive particles; and c) from 5 to 40% of a volatile by weight of the total weight of the composition, wherein said volatile has a boiling point higher than 130°C, and wherein said composition has no crossing over of the storage modulus (G') and the loss modulus (G"), and wherein the storage modulus (G') is lower than the loss modulus (G").

The present invention also encompasses a cured product of a composition according to the present invention.

The present invention also relates to use of a composition according to the present invention in Laser Induced Forward Transfer (LIFT) process.

### Detailed description of the invention

In the following passages the present invention is described in more detail. Each aspect so described may be combined with any other aspect or aspects unless clearly indicated to the contrary. In particular, any feature indicated as being preferred or advantageous may be combined with any other feature or features indicated as being preferred or advantageous.

In the context of the present invention, the terms used are to be construed in accordance with the following definitions, unless a context dictates otherwise.

As used herein, the singular forms "a", "an" and "the" include both singular and plural referents unless the context clearly dictates otherwise.

The terms "comprising", "comprises" and "comprised of" as used herein are synonymous with "including", "includes" or "containing", "contains", and are inclusive or open-ended and do not exclude additional, non-recited members, elements or method steps.

The recitation of numerical end points includes all numbers and fractions subsumed within the respective ranges, as well as the recited end points.

All percentages, parts, proportions and then like mentioned herein are based on weight unless otherwise indicated.

When an amount, a concentration or other values or parameters is/are expressed in form of a range, a preferable range, or a preferable upper limit value and a preferable lower limit value, it should be understood as that any ranges obtained by combining any upper limit or preferable value with any lower limit or preferable value are specifically disclosed, without considering whether the obtained ranges are clearly mentioned in the context.

All references cited in the present specification are hereby incorporated by reference in their entirety.

Unless otherwise defined, all terms used in disclosing the invention, including technical and scientific terms, have the meaning as commonly understood by one of the ordinary skill in the art to which this invention belongs to. By means of further guidance, term definitions are included to better appreciate the teaching of the present invention.

Surprisingly, the Applicant has discovered that by altering the rheological behaviour of the composition it can be adjusted to be suitable for the LIFT process. In accordance with the present invention, there is provided a composition, which is suitable for use in the LIFT process. Therefore, the composition according to the present invention provides fast application technique and reproducible results.

The present invention relates to a composition comprising a) one or more resin; b) electrically conductive particles and/or non-conductive particles and/or thermally conductive particles; and c) from 5 to 40% of a volatile by weight of the total weight of the composition, wherein said volatile has a boiling point higher than 130°C, and wherein said composition has no crossing over of the storage modulus (G') and the loss modulus (G"), and wherein the storage modulus (G') is lower than the loss modulus (G").

A composition according to the present invention is for use in Laser Induced Forward Transfer (LIFT) process.

A composition according to the present invention comprises one or more resin.

Suitable resin for use in the present invention can be a thermoset resin and/or a thermoplastic resin. The suitable resin is preferably selected from the group consisting of polyurethanes, polyesters, polyacrylates, polysiloxanes, halogenated vinyl or vinylidene polymers, polyamide copolymers, phenoxy resins, polyethers, polyketones, polyvinyl butyral, polyvinyl pyrrolidone, polyacrylates, polyimides, polyols, cellulose, epoxide, silicones, acrylates, bismaleimides, benzoxazines, cyanate esters, olefins, phenolic resins, oxetanes, vinyl ethers and mixtures thereof.

Suitable commercially available resins for use in the present invention include, but are not limited to PKHJ from InChem, EPU-78-11 from ADEKA, Epalloy 5000 from CVC Specialty Chemicals, Paraloid B44 from DOW, Epiclon 850S from DIC, Estane 5715 from Lubrizol, Vitel 2200B from Bostik and Solbin TA3 from Shin Etsu.

A composition according to the present invention comprises resin from 3 to 30% by weight of the total weight of the composition, preferably from 5 to 25%, more preferably from 8 to 23%, and even more preferably from 17 to 23%.

If the quantity of resin is less than 3 %, the composition does not adhere properly. On the other hand if the resin quantity is more than 30% the conductivity of the composition decreases.

A composition according to the present invention comprises a volatile. A volatile according to the present invention covers both solvents and reactive diluents and mixtures thereof. By the term "reactive diluent" is meant herein a compound that acts as a solvent in the composition according to the present invention, lowering the viscosity, and chemically reacts into the final composition during cure. By the term "solvent" is meant herein a substance that dissolves a solute, resulting in a mixture/composition having a lower viscosity.

A composition according to the present invention comprises a volatile from 5 to 40% by weight of the total weight of the composition. When the amount of volatile that is evaporated upon exposure to the laser pulse is too high, no proper gas bubble is formed, and therefore, no jet will be formed. Instead the gas bubble in the material expands very fast and the material explodes. This explosion of the composition is avoided when the volatile content is between 5 and 40%. Preferably, a composition according to the present invention comprises a volatile from 5 to 30% by weight of the total weight of the composition, more preferably from 6 to 20%, and even more preferably from 7 to 17%.

Suitable volatile for use in the present invention has a boiling point higher than 130°C, preferably the volatile has a boiling point higher than 200°C, but less than 300°C.

High volatile boiling point is preferred because more energy is required for the material to get to the gas phase, therefore the material will expand a bit, but not as drastically to cause an explosion.

Preferably, a suitable volatile for use in the present invention is selected from the group consisting of dipropylene glycol, diethylene glycol, triethylene glycol, diacetone alcohol, 2-ethyl-1,3-hexanediol, tridecanol, 1,2-octanediol, butyldiglycol, alpha-terpineol or beta-terpineol, 2-(2-butoxyethoxy)ethyl acetate, 2,2,4-trimetyl-1,3-pentanediol diisobutyrate, 1,2-propylene carbonate, carbitol acetate, butyl carbitol acetate, butyl carbitol, ethyl carbitol acetate, 2-phenoxy ethanol, hexylene glycol, dibasic ester (DBE), dibasic ester 9 (DBE-9), dibasic ester 7 (DBE-7), isobornyl acrylate, 1,4-butanediol diglycidyl ether, mono (C12-14-alkyloxy)methyl-oxirane and mixtures thereof.

Suitable commercially available volatiles for use in the present invention include, but are not limited to Erisys GE-11 and Erisys GS-120 from CVC Specialty chemicals, SR 238 from Crayvalley and Vikolox 14 from Atofina.

A composition according to the present invention comprises electrically conductive particles and/or non-conductive particles and/or thermally conductive particles. Type of the particle is selected depending of the purpose of use.

Suitable electrically conductive particles for use in the present invention are selected from the group consisting of silver, nickel, carbon, carbon black, graphite, graphene, copper, gold, platinum, aluminium, iron, zinc, cobalt, lead, tin alloys, silver coated fillers such as silver coated copper, silver coated graphite, silver coated polymers and mixtures thereof. Preferably electrically conductive particles are selected from the group consisting of silver, carbon black, graphite, graphene, copper, silver coated fillers such as silver coated copper, silver coated graphite, silver coated polymers and mixtures thereof.

Suitable commercially available electrically conductive particles for use in the present invention include, but are not limited to Ensaco 250G from Timcal and Vulcan XC72R from Cabot Corporation, Printex XE2B from Evonik, FA-SAB-239 from DOWA, GA 238-11 from Metalor, AgCu 0305 and AgCu 0810 from Ferro and KP-84 from Ames Goldsmith.

The suitable thermally conductive particles for use in the present invention may comprise any suitable thermally conductive material, including non-conductive particles. More specifically, suitable thermally conductive particles and/or non-conductive particles for use in the present invention are selected from the group consisting of silica, alumina, nano silica, nano alumina, zinc oxide, magnesium oxide, calcium silicate, aluminum hydroxide, magnesium hydroxide, calcium carbonate, magnesium carbonate boron nitride, aluminum nitride and mixtures thereof.

Suitable commercially available thermally conductive particles and/or non-conductive particles for use in the present invention include, but are not limited to silica and oxidized alumina "ADMAFINE" series from Admatechs Company Limited and silica "SNOWTEX" series from Nissan Chemical Ind..

A composition according to the present invention comprises particles from 20 to 95% by weight of the total weight of the composition, preferably from 50 to 85%, more preferably from 75 to 85% and even more preferably from 73 to 80%.

If the quantity of the electrically conductive and/or thermally conductive particles is less than 20%, the conductivity of the composition will be lost. On the other hand if the quantity of the particles is higher than 95%, the composition is too dry, and can no longer be applied.

A composition according to the present invention may further comprise a catalyst.

Suitable catalysts for use in the present invention are for example peroxyesters, diacyl peroxides, peroxyketals, hydroperoxides, dialkyl peroxides, peroxy(di)carbonates, amines, amides, imidazoles azo initiators and photoinitiators.

Suitable commercially available catalysts for use in the present invention include, but are not limited to Trigonox, Perkadox and Laurox from Akzo Nobel, Luperox from Arkema, AIBN, Irgacure 819, Irgacure 184 and Irgacure 651 from CIBA, Ancamide 2264 and Ancamine 2638 from Air Products.

A composition according to the present invention may comprise from 0.5 to 5% of a catalyst by weight of the total weight of the composition, preferably from 1 to 4%, more preferably from 1.75 to 3%.

A composition according to the present invention may further comprise one or more additives. Suitable additives for use in the present invention are for example rheological additives, wetting agents, dispersing agents, defoamers, adhesion promotors, anti-corrosion agents, inhibitors, stabilizers, fluxing agents, surfactants and mixtures thereof and mixtures thereof.

During the LIFT process the material on the donor plate is exposed to a laser pulse. This pulse gives a certain energy that evaporates part of the volatile. With this pulse, a gas bubble is created in the material, which creates the jet that is needed for a good LIFT. When the viscosity of the material is too high, the material will not flow enough to form the jet that is required to place the material reproducible onto the substrate. Instead the material explodes around the gas bubble and spatters onto the substrate. Therefore, the viscosity of the composition according to the present invention is equal or less than 6 Pas. In practice, the composition according to the present invention has a viscosity from 0.1 to 6 Pas, preferably from 0.1 to 4 Pas, more preferably from 0.2 to 3 Pas, wherein viscosity is measured on rheometer AR 1000 at constant shear rate with 20 mm plate-plate configuration (0.2 mm gap, 60 sec, 25 °C).

A composition according to the present invention has no crossing over of the storage modulus (G') and the loss modulus (G"), and wherein the storage modulus (G') is lower than the loss modulus (G"). The storage modulus (G') and the loss modulus (G") are measured and determined by a stress sweep experiment with a rheometer. Measurement is done on rheometer AR 1000 in oscillation mode with varying shear rate with 20 mm plate-plate configuration (0.2 mm gap, 25 °C)

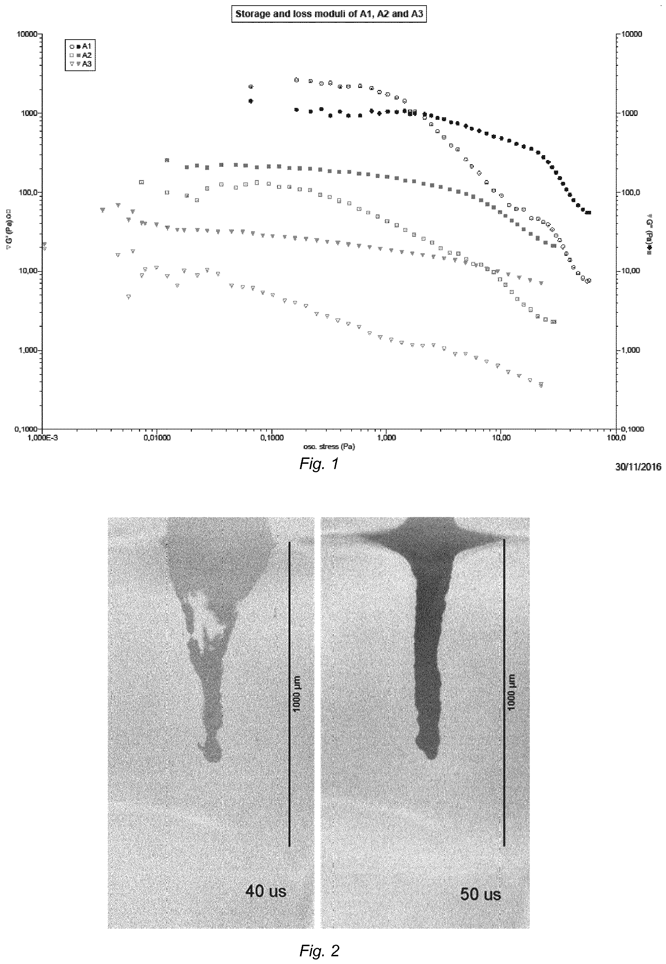

Upon formation of the gas bubble during the LIFT process, the composition according to the present invention behaves as a liquid. This means that the loss modulus (G") of the composition should be higher than the storage modulus (G') during the process. In the process the stress on the material will start low, however, during the formation of the gas bubble, the stress will gradually increase. During the whole process the material should show liquid behaviour, what means that the loss modulus should be higher at all stress levels. Figure 1 illustrates this effect. Composition A1 is not applicable with LIFT, Compositions A2 and A3 are according to the present invention and both can be applied using LIFT. The G' and G" of composition A1 show a cross-over point at a stress of 2 Pa. Compositions A2 and A3 do not show a crossover, G' is lower than G" in the whole range of applied stress. Figure 2 on the left side illustrates that an explosion of a composition was observed during LIFT process, this is due the fact that the composition has a higher storage modulus than loss modulus at lower stress levels. Figure 2 on the right side illustrates that the composition, which has a higher loss modulus than storage modulus in the whole applied stress range forms a jet.

A composition according to the present invention can be prepared by mixing all components together in any order.

The present invention also relates to a cured product of a composition according to the present invention.

A composition according to the present invention can be used in Laser Induced Forward Transfer (LIFT) process.

### Examples

The examples described hereunder exemplify the properties of the compositions according to the embodiments of the present invention. The following examples are included for purposes of illustration so that the disclosure may be more readily understood and are in no way to be intended to limit the scope of the disclosure unless otherwise specifically indicated.

### Example 1

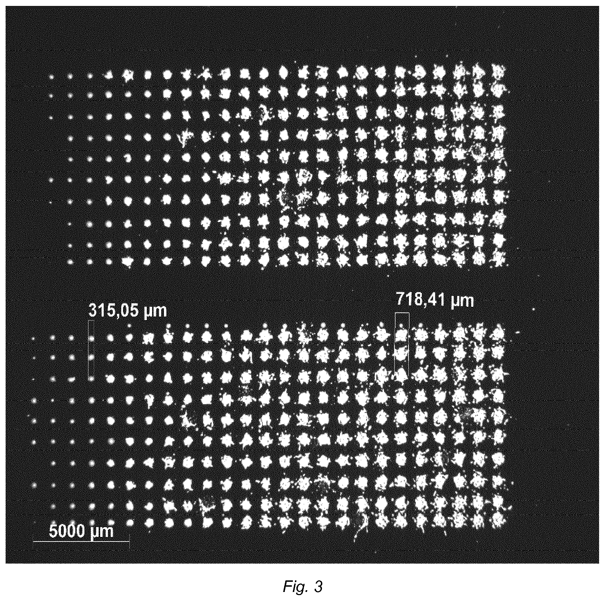

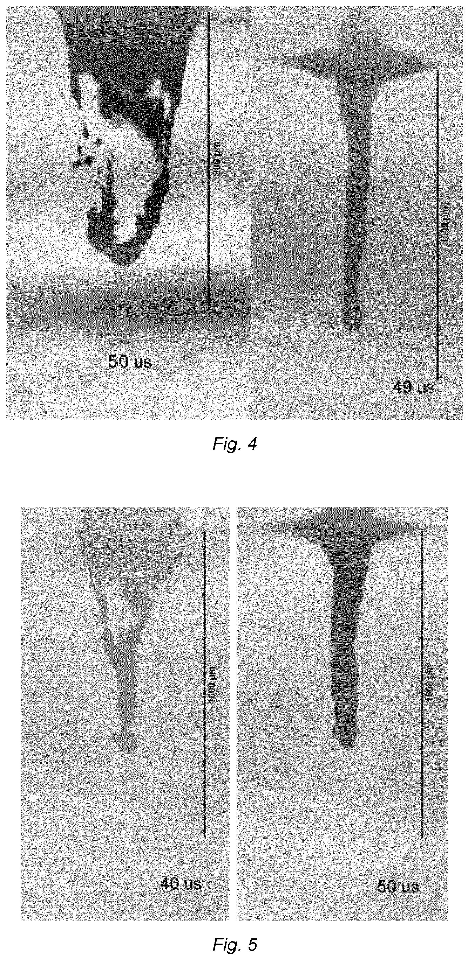

Composition A3 and composition B had a differed viscosity. Detailed compositions are listed in the table 1. The viscosity of composition B was lowered by addition of a volatile component. Testing showed that the composition B was not applicable with LIFT (illustrated in figure 3), whereas lower viscosity composition A3 was applicable with LIFT. Figure 4 illustrates this effect. Explosion of a material was observed during LIFT process as can be seen on the left side of the figure 4 when the composition having a high viscosity (composition B) was used in LIFT process. A jet was formed, as can be seen on the right side of the figure 4, for the composition having a suitable viscosity (composition A3).

**Table 1**

| **Component** | **Composition A3** | **Composition B** |
|---|---|---|
| Linear bifunctional epoxy | 8.06 | 8.06 |
| Bis F epoxy | 12.10 | 12.10 |
| Seikacure S (amine hardener) | 2.52 | 2.52 |
| Micron sized silver flake | 77.12 | 77.12 |
| Epoxy silane compound | 0.20 | 0.20 |
| Organic solvent bp. (213-218°C) | 15.00 | 0.00 |
| Viscosity (Pas) | 1.0 | 11.1 |
| Crossover of G' and G" | No | Yes |
| Applicable with LIFT | Yes | No |

### Example 2

Composition C and composition D had a differed volatile used in the composition, more specifically, boiling point of the volatile was different. Detailed compositions are listed in table 2. Testing showed that the composition C was not applicable with LIFT, whereas composition D was applicable with LIFT. Figure 5 illustrates this effect. Explosion of the material was observed during LIFT process using the composition comprising low boiling point volatile (composition C), as can be seen on the left side of the figure 5. Whereas, the composition comprising a high boiling point volatile (composition D), a jet was formed as can be seen on the right side of the figure 5.

**Table 2**

| **Component** | **Composition C** | **Composition D** |
|---|---|---|
| Linear bifunctional epoxy | 8.06 | 8.06 |
| Bis F epoxy | 12.10 | 12.10 |
| Seikacure S (amine hardener) | 2.52 | 2.52 |
| Micron sized silver flake | 77.12 | 77.12 |
| Epoxy silane compound | 0.20 | 0.20 |
| Epoxy diluent 1 (BP 124°C) | 8.00 | 0.00 |
| Epoxy diluent 2 (BP >250°C) | 0.00 | 8.00 |
| Viscosity (Pas) | 1.9 | 2.0 |
| Crossover of G' and G" | Yes | No |
| Applicable with LIFT | No | Yes |

### Example 3

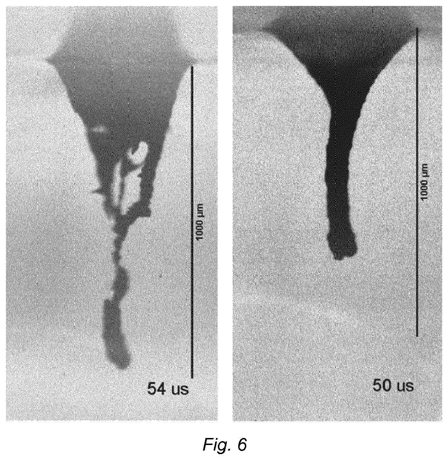

Composition A1 and composition E had a differed quantity of the volatile used in the composition. Detailed compositions are listed in table 3. Testing showed that the composition A1 was not applicable with LIFT, whereas composition E was applicable with LIFT. Figure 6 illustrates this effect. Explosion of the material was observed during LIFT process using the composition comprising lower quantity of the volatile (composition A1), as can be seen on the left side of the figure 6. Whereas, the composition comprising a higher quantity of the volatile (composition E), a jet was formed as can be seen on the right side of the figure 6.

**Table 3**

| **Component** | **Composition A1** | **Composition E** |
|---|---|---|
| Linear bifunctional epoxy | 8.06 | 8.06 |
| Bis F epoxy | 12.10 | 12.10 |
| Seikacure S (amine hardener) | 2.52 | 2.52 |
| Micron sized silver flake | 77.12 | 77.12 |
| Epoxy silane compound | 0.20 | 0.20 |
| Organic solvent bp. (213-218°C) | 2.00 | 8.00 |
| Viscosity (Pas) | 7.0 | 2.6 |
| Crossover of G' and G" | Yes | No |
| Applicable with LIFT | No | Yes |

### Example 4

Composition A2 was prepared according to the present invention and it has no crossing over of the storage modulus (G') and the loss modulus (G"). Furthermore, the storage modulus (G') is lower than the loss modulus (G") as illustrated in figure 1.

**Table 4**

| **Component** | **Composition A2** |
|---|---|
| Linear bifunctional epoxy | 8.06 |
| Bis F epoxy | 12.10 |
| Seikacure S (Amine hardener) | 2.52 |
| Micron sized silver flake | 77.12 |
| Epoxy silane compound | 0.20 |
| Organic solvent (BP 213 - 218°C) | 8.00 |
| Viscosity (Pas) | 2.7 |
| Crossover of G' and G" | No |
| Applicable with LIFT | Yes |

### Example 5

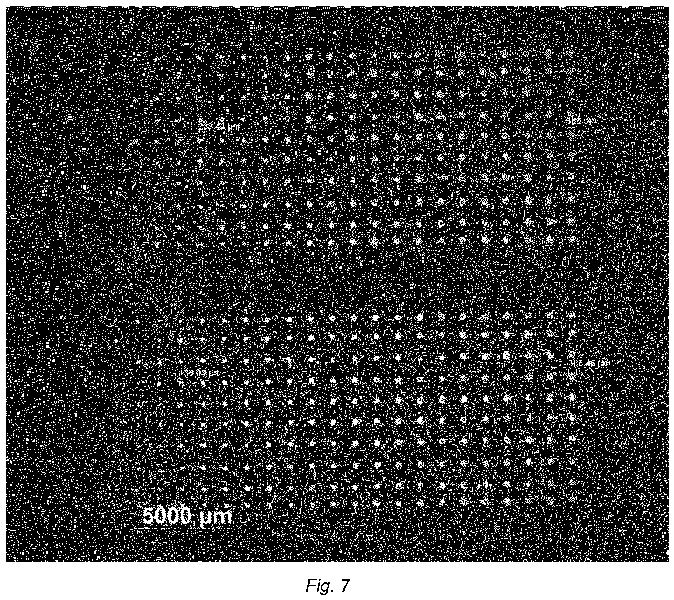

Table 5 exemplify two additional compositions according to the present invention, which are suitable for use in LIFT process. This is illustrated in figure 7, reproducible dots were produced from composition G.

**Table 5**

| **Component** | **Composition F** | **Composition G** |
|---|---|---|
| Chlorinated thermoplastic resin | 4.5 | 6.90 |
| Thermoplastic polyurethane | 0 | 0.90 |
| Micron sized silver flake | 80.0 | 54.42 |
| Organic acid | 0 | 0.04 |
| Disperbyk 110 from BYK (wetting and dispersing agent) | 0 | 0.55 |
| Organic solvent 1 (BP 196-215°C) | 15.5 | 16.04 |
| Organic solvent 2 (BP 190°C) | 0 | 21.15 |
| Crossover of G' and G" | No | No |
| Applicable with LIFT | Yes | Yes |

## Claims

1. A composition comprising
a) one or more resin;
b) electrically conductive particles and/or non-conductive particles and/or thermally conductive particles; and
c) from 5 to 40% of a volatile by weight of the total weight of the composition,
wherein said volatile has a boiling point higher than 130°C, and
wherein said composition has no crossing over of the storage modulus (G') and the loss modulus (G"), and wherein the storage modulus (G') is lower than the loss modulus (G").

2. A composition according to claim 1, wherein composition comprises from 5 to 30% of a volatile by weight of the total weight of the composition, preferably from 6 to 20%, more preferably from 7 to 17%.

3. A composition according to claim 1 or 2, wherein said volatile has a boiling point higher than 200°C.

4. A composition according to any of claims 1 to 3, wherein composition comprises from 3 to 30% of resin by weight of the total weight of the composition, preferably from 5 to 25%, more preferably from 8 to 23%, and even more preferably from 17 to 23%.

5. A composition according to any of claims 1 to 4, wherein said resin can be a thermoset resin and/or a thermoplastic resin, and is preferably selected from the group consisting of polyurethanes, polyesters, polyacrylates, polysiloxanes, halogenated vinyl or vinylidene polymers, polyamide copolymers, phenoxy resins, polyethers, polyketones, polyvinyl butyral, polyvinyl pyrrolidone, polyacrylates, polyimides, polyols, cellulose, epoxide, silicones, acrylates, bismaleimides, benzoxazines, cyanate esters, olefins, phenolic resins, oxetanes, vinyl ethers and mixtures thereof.

6. A composition according to any of claims 1 to 5, wherein said composition comprises from 20 to 95% of particles by weight of the total weight of the composition, preferably from 50 to 85%, more preferably from 75 to 85% and even more preferably from 73 to 80%.

7. A composition according to any of claims 1 to 6, wherein said electrically conductive particles are selected from the group consisting of silver, nickel, carbon, carbon black, graphite, graphene, copper, gold, platinum, aluminium, iron, zinc, cobalt, lead, tin alloys, silver coated fillers such as silver coated copper, silver coated graphite, silver coated polymers and mixtures thereof.

8. A composition according to any of claims 1 to 7, wherein said thermally conductive particles and/or non-conductive particles are selected from the group consisting of silica, alumina, nano silica, nano alumina, zinc oxide, magnesium oxide, boron nitride, aluminum nitride and mixtures thereof

9. A composition according to any of claims 1 to 8, wherein said composition further comprises a catalyst.

10. A composition according to claim 9, wherein said composition comprises from 0.5 to 5% of a catalyst by weight of the total weight of the composition, preferably from 1 to 4%, more preferably from 1.75 to 3%.

11. A composition according to any of claims 1 to 10, wherein said composition may further comprise one or more additive, wherein said additive is selected from the group consisting of rheological additives, wetting agents, dispersing agents, defoamers, adhesion promotors, anti-corrosion agents, inhibitors, stabilizers, fluxing agents, surfactants and mixtures thereof and mixtures thereof.

12. A composition according to any of claims 1 to 11, wherein said composition has a viscosity from 0.1 to 6 Pas, preferably from 0.1 to 4 Pas, more preferably from 0.2 to 3 Pas, wherein viscosity is measured on a rheometer AR 1000 at constant shear rate with 20 mm plate-plate configuration (0.2 mm gap, 60 sec, 25°C).

13. A cured product of a composition according to any of claims 1 to 12.

14. Use of a composition according to any of claims 1 to 12 in Laser Induced Forward Transfer process.
